Europäisches Patentamt

European Patent Office

Office européen des brevets

(11) Veröffentlichungsnummer: **0 510 441 A1**

# EUROPÄISCHE PATENTANMELDUNG

(21) Anmeldenummer: **92106137.0**

(51) Int. Cl.⁵: **G03F 7/004**

(22) Anmeldetag: **09.04.92**

(30) Priorität: **20.04.91 DE 4112973**

(43) Veröffentlichungstag der Anmeldung:
**28.10.92 Patentblatt 92/44**

(84) Benannte Vertragsstaaten:
**BE CH DE FR GB IT LI NL**

(71) Anmelder: **HOECHST AKTIENGESELLSCHAFT**
**Postfach 80 03 20**
**W-6230 Frankfurt am Main 80(DE)**

(72) Erfinder: **Röschert, Horst, Dr.**
**Am Pfingstborn 16**
**W-6531 Ober Hilbersheim(DE)**
Erfinder: **Fuchs, Jürgen**
**Flörsheimer Strasse 40**
**W-6093 Flörsheim/Wicker(DE)**
Erfinder: **Spiess, Walter, Dr.**
**Rheingaustrasse 20**
**W-6110 Dieburg(DE)**
Erfinder: **Eckes, Charlotte**
**Zugspitzstrasse 15**
**W-6200 Wiesbaden-Dotzheim(DE)**
Erfinder: **Pawlowski, Georg, Dr.**
**Fritz-Kalle-Strasse 34**
**W-6200 Wiesbaden(DE)**

(54) **Positiv arbeitendes strahlungsempfindliches Gemisch und damit hergestelltes strahlungsempfindliches Aufzeichnungsmaterial.**

(57) Die Erfindung betrifft ein positiv arbeitendes, strahlungsempfindliches Gemisch mit

a) einer Verbindung, die unter Einwirkung von aktinischer Strahlung eine starke Säure bildet,

b) einer Verbindung mit mindestens einer durch Säure spaltbaren C-O-C- oder C-O-Si-Bindung und

c) einem in Wasser unlöslichen, in wäßrig-alkalischen Lösungen löslichen oder zumindest quellbaren polymeren Bindemittel,

das dadurch gekennzeichnet ist, daß die Verbindung (a) ein mit Sulfonsäuren der allgemeinen Formel R-SO₃H verestertes 1,3,5- oder 1,2,4-Trihydroxy-benzol oder ein am aromatischen Ring mit einem Rest R' substituiertes 1,2,3-, 1,3,5- oder 1,2,4-Trihydroxybenzol darstellt, wobei R und R' gleiche oder verschiedene Bedeutung haben und R einen ggf. weiter substituierten ($C_1$-$C_{10}$)Alkyl-, ($C_5$-$C_{10}$)Cycloalkyl-, ($C_6$-$C_{10}$)Aryl-, ($C_6$-$C_{10}$)Aryl-($C_1$-$C_{10}$)-alkyl- oder ($C_3$-$C_9$)Heteroarylrest und R' einen der für R genannten Reste, einen ($C_1$-$C_{10}$)Alkanoyl-, ($C_1$-$C_{16}$)-Alkoxycarbonyl- oder einen ($C_7$-$C_{11}$)Aroylrest bezeichnet.

Das erfindungsgemäße, strahlungsempfindliche Gemisch zeichnet sich durch eine hohe Auflösung und eine hohe Empfindlichkeit über einem weiten Spektralbereich aus. Es zeigt ebenso eine hohe thermische Stabilität und bildet bei Belichtung keine korrodierenden Photolyseprodukte.

Die Erfindung betrifft weiterhin ein daraus hergestelltes, strahlungsempfindliches Aufzeichnungsmaterial, das zur Herstellung von Photoresists, elektronischen Bauteilen, Druckplatten oder zum Formteilätzen geeignet ist.

Die Erfindung betrifft ein positiv arbeitendes strahlungsempfindliches Gemisch mit

a) einer Verbindung, die unter Einwirkung von aktinischer Strahlung eine starke Säure bildet,

b) einer Verbindung mit mindestens einer durch Säure spaltbaren C-O-C- oder C-O-Si-Bindung und

c) einem in Wasser unlöslichen, in wäßrig-alkalischen Lösungen löslichen oder zumindest quellbaren polymeren Bindemittel.

Die Erfindung betrifft weiterhin ein damit hergestelltes strahlungsempfindliches Aufzeichnungsmaterial, das zur Herstellung von Photoresists, elektronischen Bauteilen, Druckplatten oder zum Formteilätzen geeignet ist.

Die stetige Verkleinerung der Strukturen, beispielsweise in der Chip-Herstellung bis in den Bereich von weniger als 1 μm, erfordert veränderte lithographische Techniken. Um solche feinen Strukturen abzubilden, verwendet man Strahlung mit einer kurzen Wellenlänge, wie energiereiches UV-Licht, Elektronen- und Röntgenstrahlen. Das strahlungsempfindliche Gemisch muß an die kurzwellige Strahlung angepaßt sein. Eine zusammenstellung der an das strahlungsempfindliche Gemisch gestellten Forderungen ist in dem Aufsatz von C.G. Willson "Organic Resist Materials - Theory and Chemistry" [Introduction to Microlithography, Theory, Materials, and Processing, Herausgeber L.F. Thompson, C.G. Willson, M.J. Bowden, ACS Symp. Ser., 219, 87 (1983), American Chemical Society, Washington] angegeben. Es bestand daher ein verstärkter Bedarf an strahlungsempfindlichen Gemischen, die in den neueren Technologien, wie der Mid- oder Deep-UV-Lithographie, [Belichtung z. B. mit Excimer-Lasern bei Wellenlängen von 305 nm (XeF), 248 nm (KrF), 193 nm (ArF)], der Elektronen- oder der Röntgenstrahl-Lithographie, einsetzbar sind, vorzugsweise darüber hinaus in einem weiten Spektralbereich empfindlich sind und dementsprechend auch in der konventionellen UV-Lithographie verwendet werden können.

Gemische, die neben einem in Wasser unlöslichen, in wäßrig-alkalischen Lösungen löslichen oder zumindest quellbaren Bindemittel und einer unter Einwirkung von aktinischer Strahlung eine starke Säure bildenden Komponente als wesentlichen Bestandteil eine durch Säure spaltbare Verbindung, mit z. B. C-O-C- oder C-O-Si-Bindungen, aufweisen, sind prinzipiell bekannt, beispielsweise aus der DE-A 23 06 248 ( = US-A 3 779 778).

Als Verbindungen, die bei Bestrahlung eine starke Säure bilden, wurden bisher insbesondere Onium-Salze, wie Diazonium-, Phosphonium-, Sulfonium- und Jodonium-Salze von nicht nucleophilen Säuren, wie $HSbF_6$, $HAsF_6$, oder $HPF_6$ [J.V. Crivello, Polym. Eng. Sci., 23 (1983) 953], verwendet. Daneben sind Halogenverbindungen, insbesondere Trichlormethyltriazin-Derivate oder Trichlormethyloxadiazol-Derivate, o-Chinondiazidsulfochloride, o-Chinondiazid-4-sulfonsäureester, Organometall-Organohalogen-Kombinationen, Bis(sulfonyl)diazomethane, Sulfonyl-carbonyl-diazomethane (DE-A 39 30 087) oder Nitrobenzyltosylate [F.M. Houlihan et al., SPIE Proc., Adv. in Resist Techn. and Proc. 920 (1988) 67] empfohlen worden.

Diese Verbindungen werden in negativ oder positiv arbeitenden strahlungsempfindlichen Gemischen verwendet. Die Verwendung derartiger photolytischer Säurebildner bringt aber gewisse Nachteile mit sich, die ihre Einsatzmöglichkeiten in verschiedenen Anwendungsbereichen drastisch einschränken. So sind z.B. viele der Oniumsalze toxisch. Ihre Löslichkeit ist in vielen Lösemitteln unzureichend, weshalb nur wenige Lösemittel zur Herstellung einer Beschichtungslösung geeignet sind. Darüber hinaus werden bei Verwendung der Oniumsalze z.T. unerwünschte Fremdatome eingeführt, die insbesondere in der Mikrolithographie zu Prozeßstörungen führen können. Ferner bilden die Oniumsalze bei der Photolyse sehr stark korrodierend wirkende Brönstedt-Säuren. Diese Säuren greifen empfindliche Substrate an, so daß der Einsatz solcher Gemische zu unbefriedigenden Ergebnissen führt. Wie bereits früher erwähnt, bilden auch die Halogenverbindungen sowie die Chinondiazidsulfonsäurechloride stark korrosiv wirkende Halogenwasserstoffsäuren. Ferner besitzen derartige Verbindungen auf bestimmten Substraten nur eine begrenzte Haltbarkeit, die dadurch verbessert wurde, daß zwischen Substrat und strahlungsempfindlicher, Verbindungen des Typs (a) enthaltender Schicht eine Zwischenschicht eingefügt wurde, was allerdings zu einer unerwünschten Zunahme von Defekten und zu einer verminderten Reproduzierbarkeit führte (DE-A 36 21 376 = US-A 4 840 867).

In neueren Arbeiten von F.M. Houlihan et al., SPIE 920, 67 (1988) wurden anhand positiv arbeitender Systeme gezeigt, daß neben den oben genannten Säurebildnern auch Nitrobenzyltosylate, die bei Belichtung Sulfonsäuren mit geringer Wanderungstendenz bilden, in bestimmten säurelabilen Resistformulierungen verwendbar sind. Es kann aus diesen Ergebnissen abgeleitet werden, daß solche Verbindungen auch für photohärtbare Systeme verwendet werden können. Die dabei erzielten Empfindlichkeiten und die thermische Stabilität der Photoresists erwiesen sich jedoch als unzureichend.

Bereits bekannt sind auch Resistformulierungen mit Naphthochinon-2-diazid-4-sulfonsäureestern, Oximsulfonaten, 1,2-Disulfonen, Bis-sulfonyl-diazomethan (DE-A 39 30 086) und Sulfonyl-carbonyl-diazomethan (DE-A 39 30 087). All diese Verbindungen bilden unter der Einwirkung aktinischer Strahlung nicht korrodierend wirkende Sulfonsäuren. Die photochemische Reaktion verläuft zudem mit einer unbefriedigenden Quantenausbeute. Die Resistformulierungen absorbieren Strahlung der Wellenlänge 248 nm in beträchtlichem Maße. Die Empfindlichkeit gegenüber Strahlung dieser Wellenlänge liegt im Bereich von 50 bis 100 mJ/cm$^2$. Praxisgerechte Strukturen einer Größenordnung von 0,5 $\mu$m und weniger lassen sich mit solchen Resists nicht abbilden.

Es ist ferner bekannt, mit Methan-, Ethan-, Propan-, Butan-, Benzol-, Toluol- oder Naphthalinsulfonsäure vollständig verestertes 1,2,3-Trihydroxy-benzol als photoaktiven Säurebildner in positiv arbeitenden Photoresistsystemen zu verwenden [T. Ueno et al., Chemical Amplification Positive Resist Systems Using Novel Sulfonates as Acid Generators, in "Polymers for Microelectronics - Science and Technology", Hrsg. Y. Tabata et al., Kodansha-Weinheim-New York, 1989, S. 66-67]. Diese Resistsysteme finden jedoch in der Praxis keine Verwendung, da ihre thermische Stabilität und Plasmaätzresistenz unzureichend ist und nach der Entwicklung Resistreste in den Gräben und nicht akzeptable Resistprofile zu beobachten sind.

Trotz der bisher geleisteten intensiven Forschungstätigkeit auf diesem Gebiet ist derzeit kein strahlungsempfindliches Gemisch bekannt, mit dem sich ein positiv arbeitendes strahlungsempfindliches Aufzeichnungsmaterial herstellen läßt, das eine hohe Empfindlichkeit im DUV-Bereich (200 bis 300 nm) sowie eine hohe Auflösung besitzt, bereits bei kurzzeitiger Bestrahlung eine ausreichende Menge einer nicht korrodierend wirkenden Säure freisetzt, die stark genug ist, um Verbindungen des Typs b) zu spalten und das zudem noch wäßrig-alkalisch entwickelbar ist.

Aufgabe der Erfindung war es daher, ein strahlungsempfindliches Gemisch auf Basis von säurebildenden in Kombination mit säurespaltbaren Verbindungen vorzuschlagen, wobei die photolytisch eine Säure bildende Verbindung (a) möglichst stabil auf allen bekannten Substraten sein sollte und als Photoprodukt eine nicht korrosiv wirkende Säure liefert.

Die Aufgabe wird gelöst durch ein strahlungsempfindliches Gemisch mit

a) einer Verbindung, die unter Einwirkung von aktinischer Strahlung eine starke Säure bildet,

b) einer Verbindung mit mindestens einer durch Säure spaltbaren C-O-C- oder C-O-Si-Bindung und

c) einem in Wasser unlöslichen, in wäßrig-alkalischen Lösungen löslichen oder zumindest quellbaren polymeren Bindemittel,

das dadurch gekennzeichnet ist, daß die Verbindung (a) ein mit Sulfonsäuren der allgemeinen Formel R-SO$_3$H verestertes 1,3,5- oder 1,2,4-Trihydroxy-benzol oder ein am aromatischen Ring mit einem Rest R' substituiertes 1,2,3-, 1,3,5- oder 1,2,4-Trihydroxybenzol darstellt, wobei R und R' gleiche oder verschiedene Bedeutung haben und R einen ggf. weiter substituierten (C$_1$-C$_{10}$)Alkyl-, (C$_5$-C$_{10}$)Cycloalkyl-, (C$_6$-C$_{10}$)Aryl-, (C$_6$-C$_{10}$)Aryl-(C$_1$-C$_{10}$)alkyl- oder (C$_3$-C$_9$)Heteroarylrest und R' einen der für R genannten Reste, einen (C$_1$-C$_{10}$)Alkanoyl-, (C$_1$-C$_{16}$)Alkoxy-carbonyl- oder einen (C$_7$-C$_{11}$)Aroylrest bezeichnet.

Geeignete Sulfonsäuren R-SO$_3$H sind beispielsweise Methan-, Ethan-, Propan-, Isopropan-, Butan-, sec.-Butan-, Isobutan-, tert.-Butan-, Pentan-, Hexan- und Octansulfonsäure, daneben auch Cyclohexan-, Phenylmethan-, 2-Phenyl-ethan-, 3-Phenyl-propan-, Benzol- und Naphthalinsulfonsäure.

Schließlich sind heteroaromatische Sulfonsäuren geeignet. Die Heteroarylsulfonsäuren weisen neben 4 bis 9 Kohlenstoffatomen noch ein aromatisches Sauerstoff- oder Schwefelatom oder 1 oder 2 aromatische Stickstoffatome auf. Beispiele hierfür sind die Furan- und Thiophensulfonsäuren, die Pyrrol-, Pyridin-, Pyrimidin-und Pyrazin-sulfonsäuren. Auch Sulfonsäuren mit einem zweikernigen Heteroarylrest sind geeignet. Hierfür seien die Benzofuran-, Isobenzofuran-, Benzo[b]thiophen- und Indolsulfonsäuren genannt. Die stickstoffhaltigen Heterocyclen dürfen jedoch nicht basisch sein.

Die Reste R und R' können substituiert sein. Im Prinzip können alle Substituenten, die keine unerwünschten Reaktionen eingehen, vorkommen. Geeignete Substituenten sind lineare und verzweigte Alkylgruppen mit vorzugsweise nicht mehr als 8 Kohlenstoffatomen, insbesondere nicht mehr als 6 Kohlenstoffatomen, wie Methyl, Ethyl, Propyl, Isopropyl, Butyl, sec.-Butyl, Isobutyl und tert.-Butyl. Die Alkylgruppen können fluoriert, bevorzugt auch perfluoriert, sein. Von den perfluorierten Alkylresten sind Trifluormethyl und Perfluorbutyl besonders geeignet. Weitere geeignete Substituenten sind (C$_1$-C$_8$)Alkoxy, (C$_1$-C$_8$)Alkoxy-(C$_1$-C$_8$)alkoxy, (C$_1$-C$_8$)Alkanoyl, (C$_1$-C$_8$)Alkanoyloxy, (C$_1$-C$_8$)Alkanoylamino, (C$_6$-C$_{10}$)Aryl, (C$_6$-C$_{10}$)Aryloxy, (C$_6$-C$_{10}$)Aryl-(C$_1$-C$_8$)alkoxy, (C$_6$-C$_{11}$)Aroylamino, (C$_6$-C$_{11}$)Aroylamino-(C$_1$-C$_6$)alkyl, Cyano und Halogen. Die Substituenten können mehrfach auftreten. Unabhängig davon können verschiedene Substituenten nebeneinander vorhanden sein. Bevorzugte Substituenten sind (C$_1$-C$_4$)Alkyl, (C$_1$-C$_4$)Alkoxy und Phenyl. Der Phenylrest ist wiederum bevorzugt mit (C$_1$-C$_6$)Alkyl, (C$_1$-C$_8$)Perfluoralkyl und/oder Halogen, insbesondere Fluor, substituiert. Bevorzugt steht einer dieser Substituenten des Phenylrestes in der para-Position.

Der ggf. vorhandene Substituent R' ist insbesondere Methyl, Ethyl, Propyl, Isopropyl, Butyl, sec.-Butyl, Isobutyl, tert.-Butyl, Formyl, Acetyl, Methoxycarbonyl, Phenyl, Benzyl, Cyclohexyl, Benzoyl, Phenethyl, 3-Phenyl-propyl, [1]Naphthyl oder [2]Naphthyl. Die Heteroarylreste weisen neben 4 bis 9 Kohlenstoffatomen noch ein aromatisches Sauerstoff- oder Schwefelatom oder 1 oder 2 Stickstoffatome auf. Beispiele sind Furanyl-, Thiophenyl-, Pyrrolyl-, Pyridinyl- und Chinolinylreste. Wiederum gilt, daß die stickstoffhaltigen Heterocyclen nicht basisch sein dürfen. Die Reste R' können auf die gleiche Weise substituiert sein wie die Reste R. Sie können darüber hinaus auch mit Hydroxy und Sulfonyloxy (O-SO$_2$-R, wobei R die obengenannte Bedeutung hat) substituiert sein. Die aromatischen Reste R' sind bevorzugt mit (C$_1$-C$_4$)Alkoxy, (C$_1$-C$_8$)Alkanoyl, Sulfonyloxy (-O-SO$_2$-R) und Halogen substituiert. Falls mehrere Substituenten an einen aromatischen Rest gebunden sind, so sind diese bevorzugt ausgewählt aus der Gruppe bestehend aus (C$_1$-C$_4$)Alkyl, Hydroxy, Sulfonyloxy (-O-SO$_2$-R) und Halogen.

Neben ggf. substituiertem 1,3,5- und 1,2,4-Trihydroxy-benzol und substituiertem 1,2,3-Trihydroxy-benzol sind auch 2,4-, 2,5- und 3,4-Dihydroxy-phenoxy-Reste sowie 1,3,5- und 1,2,4-Trihydroxy-phenylen-Reste enthaltende Polymere als Ausgangsmaterialien zur Herstellung der mehrfunktionellen Sulfonsäureester geeignet. In solchen Polymeren kommen beispielsweise Einheiten abgeleitet aus (Meth)acrylsäure-2,4-dihydroxyphenylester vor. Daneben können in den Polymeren andere Einheiten ohne einen der genannten Reste vorhanden sein, d. h. neben Homopolymeren sind auch Co- und Terpolymere sowie Polymere noch mehr verschiedenen Einheiten geeignet. Die weiteren Einheiten leiten sich bevorzugt von Styrol, einem Hydroxystyrol, Maleimid, einem N-substituierten Maleimid, einem Vinyl-alkyl-ether und/oder einem Vinyl-alkylsilan ab. Homo- und Copolymere, insbesondere Copolymere mit Maleimid oder Styrol sind bevorzugt. Kondensationsprodukte aus einem Trihydroxybenzol, wie 1,3,5- und 1,2,4-Trihydroxy-benzol, mit einem Keton sind als Ausgangsmaterialien gleichfalls geeignet. Mehrfunktionelle Sulfonsäureester aus polymeren Ausgangsmaterialien sind jedoch nicht bevorzugt.

Bevorzugte Sulfonsäuren sind Methan-, Trichlormethan-, Trifluormethan-, Ethan-, Trifluorethan-, Propan-, Isopropan-, 3-Chlorpropan-, Butan-, Isobutan-, Perfluorbutan-, Hexan-, Perfluorhexan-, Cyclohexan-, Octan-, Perfluoroctan-, Phenylmethan-, 2-Phenylethan-, 3-Phenylpropan-, Benzol-, 3-Perfluoroctylbenzol-, 4-Trifluormethylbenzol-, 4-Perfluorbutylbenzol-, 4-Tolyl-, 4-Bromobenzol-, 4-Cyanobenzol-, 4-tert.-Butylbenzol-, 2,4,5-Trimethylbenzol-, 3,4-Dichlorbenzol-, (+)Campher-10- und 2-Benzoylaminomethyl-thiophen-5-sulfonsäure.

Besonders geeignete Ausgangsverbindungen mit phenolischen Hydroxygruppen sind: 1,3,5-Trihydroxy-benzol, 1,2,4-Trihydroxy-benzol, Poly[methacrylsäure-(2,3-dihydroxy-phenyl)-ester], Poly-[methacrylsäure-(3,5-dihydroxy-phenyl)-ester], Poly[methacrylsäure-(2,4-dihydroxyphenyl)-ester], 2,3,4-Trihydroxy-benzaldehyd, Gallusaldehyd, Gallussäuremethylester, Gallussäure-propylester, Gallussäure-octylester, Gallussäure-dodecylester, 2,3,4-Trihydroxybenzophenon, 2,4,6-Trihydroxybenzophenon, 2,3,4-Trihydroxyacetophenon, 2,4,6-Trihydroxyacetophenon, 1-Octanoyl-2,3,4-trihydroxy-benzol, 1-Hexanoyl-2,3,5-trihydroxy-benzol, 1-Butyryl-2,4,6-trihydroxy-benzol, 1-Octanoyl-2,4,6-trihydroxy-benzol, 1-Hexanoyl-2,4,6-trihydroxy-benzol sowie Kondensationsprodukte aus 1,3,5-Trihydroxy-benzol und Ketonen. Von den Polymeren sind die mit Dihydroxyphenoxygruppen allgemein bevorzugt. Nicht vollständig veresterte Produkte, d. h. solche, die noch freie phenolische Hydroxygruppen aufweisen, sind in speziellen strahlungsempfindlichen Gemischen besser löslich.

Die Herstellung der in dem erfindungsgemäßen Gemisch eingesetzten, mehrfunktionellen Sulfonsäureester ist an sich bekannt. Als Ausgangsmaterialien dienen dabei in erster Linie die entsprechenden Sulfonsäurechloride. Verfahren zu Herstellung von aromatischen Sulfonsäureestern werden beispielsweise von F. Muth in: Houben-Weyl-Müller, Methoden der organischen Chemie, Bd. IX, S. 633 (und dort zitierte Literatur), Thieme-Verlag, 4. Aufl., Stuttgart 1955, und von S. Pawlenko, a.a.O., Bd. E 11, S. 1084, Thieme-Verlag, 1. Aufl., Stuttgart 1985, sowie in der Patentliteratur an zahlreichen Beispielen beschrieben. Auch die entsprechenden Sulfonsäureanhydride sind als Ausgangsmaterialien geeignet (siehe S. Pawlenko, a.a.O., Bd. E11, S. 1086, Thieme-Verlag, 1. Aufl., Stuttgart 1985, und P. J. Stang, M. Hanack, L. R. Subramaniam, Synthesis, **1982**, 85). Dies gilt insbesondere für die mit Perfluoralkyl-Gruppen substituierten Benzolsulfonsäureanhydride.

Die mehrfunktionellen Sulfonsäureester, in denen der Rest R einen mit Trifluormethyl, Trifluorethyl, einen höheren Trifluoralkyl sowie Perfluoralkyl und Perfluoralkyl substituierten Phenylrest darstellt, wurden im Gegensatz zu den übrigen beschriebenen Sulfonsäureestern durch Umsetzung der entsprechenden Sulfonsäurefluoride mit den Trimethylsilanyloxy-benzolen nach dem von H. Niederprüm, V. Beyl, P. Voss (Liebigs Ann. Chem. **1973**, 20) angegebenen Verfahren umgesetzt. Die Trimethylsilanyloxy-Derivate der Di-, Tri- und Tetrahydroxybenzole werden durch Umsetzung mit Hexamethyldisilazan analog den in den Monographien von E. W. Colvin, Silicon Reagents in Organic Synthesis, 1. Aufl., S. 91 - 97, Academic Press, London 1988, und T. W. Greene, Protective Groups in Organic Synthesis, 1. Aufl., S. 100, J. Wiley & Sons, New York 1981, beschriebenen Verfahren erhalten.

Das erfindungsgemäße, strahlungsempfindliche Gemisch zeichnet sich durch eine hohe Empfindlichkeit über einen weiten Spektralbereich aus. Es zeigt eine hohe thermische Stabilität und schafft die Möglichkeit, auch feinste Strukturen einer Vorlage detailgenau wiederzugeben. Die bei der Bestrahlung gebildete Säure wirkt nicht korrodierend, so daß das Gemisch auch auf empfindlichen Substratmaterialien Verwendung finden kann.

Überraschenderweise ist die Quantenausbeute bei der Bestrahlung der erfindungsgemäßen Gemische größer als bei der Bestrahlung bekannter Gemische mit Pyrogallol-sulfonsäureestern. Diese höhere Effizienz der Säurebildung bedeutet, daß die erfindungsgemäßen Gemische eine wesentlich gesteigerte Empfindlichkeit aufweisen. Die erfindungsgemäßen, positiv arbeitenden, strahlungsempfindlichen Gemische zeigen zudem nicht nur eine hohe thermische und Plasmaätzbeständigkeit sondern auch hervorragende lithographische Eigenschaften, die eine Auflösung im Halbmikrometer- und teilweise auch im Sub-Halbmikrometer-Bereich erlauben. Man erhält nach dem bildmäßigen Bestrahlen und anschließendem Entwickeln ein detailgetreues Abbild der Maske. Die Resistfelder weisen steile Flanken auf. In den bestrahlten Bereichen wird die Resistschicht vollständig abgelöst, d. h. es bleiben keinerlei Reste oder Rückstände der Schicht auf dem Substrat. Die bei der Photolyse gebildeten Sulfonsäuren führen zu einer effizienten Spaltung der Resist-Komponente b), was die Herstellung von hochempfindlichen, positiv arbeitenden Gemischen erlaubt.

Mit den erfindungsgemäßen Gemischen hergestellte Aufzeichnungsmaterialien zeigen überraschend eine höchsten Ansprüchen genügende Bilddifferenzierung und, noch überraschender, eine Verbesserung des Kontrasts und des Auflösungsvermögens. Die erfindungsgemäßen Gemische erlauben beispielsweise die Herstellung eines hochempfindlichen positiv arbeitenden Photoresists für energiereiche UV2-Strahlung (z. B. 248 nm).

Da das erfindungsgemäße Gemisch über einen weiten Spektralbereich empfindlich ist, ist zum bildmäßigen Bestrahlen aktinische Strahlung allgemein geeignet. Als aktinische Strahlung soll in diesem Zusammenhang jede Strahlung verstanden werden, deren Energie mindestens der des kurzwelligen sichtbaren Lichts entspricht. Geeignet ist dabei insbesondere UV-Strahlung im Bereich von 190 bis 450 nm, bevorzugt von 200 bis 400 nm, besonders bevorzugt von 200 bis 300 nm, aber auch Elektronen- oder Röntgenstrahlung.

In dem erfindungsgemäßen, strahlungsempfindlichen Gemisch können die bei Bestrahlung Säure bildenden mehrfunktionellen Sulfonsäureester allein oder in Kombination mit anderen Säurebildnern Verwendung finden. Als zusätzliche Säurebildner sind insbesondere die in der gleichzeitig eingereichten deutschen Patentanmeldung P 41 12 971.7 beschriebenen mehrfunktionellen Sulfonsäureester von 2,4,6-Tris-(2-hydroxyethoxy)-[1,3,5]triazin geeignet.

Darüber hinaus lassen sich die mehrfunktionellen Sulfonsäureester sogar mit Onium-Salzen, Halogenverbindungen, insbesondere Trichlormethyltriazinderivaten oder Trichlormethyloxadiazolderivaten, 1,2-Disulfonen, o-Chinondiazidsulfonylchloriden oder Organometall-Organohalogen-Kombinationen kombinieren. Es kommen aber auch Mischungen mit Bis(sulfonyl)diazomethanen und Sulfonyl-carbonyldiazomethanen in Frage. In solchen Gemischen können jedoch die eingangs erwähnten Nachteile wieder auftreten.

Der Anteil an mehrfunktionellen Sulfonsäureestern im erfindungsgemäßen Gemisch liegt im allgemeinen bei 0,5 bis 25 Gew.-%, bevorzugt bei 2 bis 15 Gew.-%, bezogen auf das Gesamtgewicht der Feststoffe im Gemisch.

Als säurespaltbare Verbindungen in dem erfindungsgemäßen, strahlungsempfindlichen Gemisch haben sich vor allem folgende Verbindungsklassen bewährt:

a) solche mit mindestens einer Orthocarbonsäureester- und bzw. oder Carbonsäureamidacetalgruppe, wobei die Verbindungen auch polymeren Charakter haben und die genannten Gruppen in der Hauptkette oder seitenständig auftreten können (DE-A 26 10 842 und 29 28 636),

b) oligomere oder polymere Verbindungen mit wiederkehrenden Acetal- und/oder Ketalgruppen in der Hauptkette (DE-A 23 06 248 und 27 18 254),

c) Verbindungen mit mindestens einer Enolether- oder N-Acyliminocarbonatgruppe (EP-A 0 006 626 und 0 006 627),

d) cyclische Acetale oder Ketale von $\beta$-Ketoestern oder -amiden (EP-A 0 202 196),

e) Verbindungen mit Silylethergruppen (DE-A 35 44 165 und 36 01 264),

f) Verbindungen mit Silylenolethergruppen (DE-A 37 30 785 und 37 30 783),

g) Monoacetale bzw. Monoketale von Aldehyden bzw. Ketonen, deren Löslichkeit im Entwickler zwischen 0,1 und 100 g/l beträgt (DE-A 37 30 787),

h) Ether auf der Basis tertiärer Alkohole (US-A 4 603 101) und

i) Carbonsäureester und Carbonate, deren Alkoholkomponente ein tertiärer Alkohol, ein Allylalkohol oder ein Benzylalkohol ist [US-A 4 491 628 sowie von J. M. Fréchet et al., J. Imaging Sci. 30, 59-64 (1986)].

Es können auch Mischungen der vorgenannten säurespaltbaren Materialien eingesetzt werden. Bevorzugt ist allerdings ein säurespaltbares Material, das nur einem der obengenannten Typen zugeordnet werden kann, besonders ein solches mit mindestens einer durch Säure spaltbaren C-O-C-Bindung, d. h. daß diejenigen Materialien besonders bevorzugt sind, die den Typen (a), (b), (g) und (i) angehören. Unter Typ (b) sind besonders die polymeren Acetale hervorzuheben; von den säurespaltbaren Materialien des Typs (g) insbesondere diejenigen, die sich von Aldehyden bzw. Ketonen mit einem Siedepunkt über 150 °C, vorzugsweise über 200 °C, ableiten. Besonders bevorzugt sind die in der gleichzeitig eingereichten deutschen Patentanmeldung P 41 12 968.7 beschriebenen N,O-Polyacetale.

Die Verbindung b) bzw. die Kombination von Verbindungen b) hat einen Anteil von 1 bis 50 Gew.-%, bevorzugt 10 bis 40 Gew.-%, am Gesamtgewicht der Feststoffe des strahlungsempfindlichen Gemisches.

Das erfindungsgemäße strahlungsempfindliche Gemisch enthält ferner mindestens ein polymeres, in Wasser unlösliches, in wäßrig-alkalischen Lösungen dagegen lösliches, zumindest quellbares Bindemittel c). Das Bindemittel zeichnet sich im besonderen dadurch aus, daß es mit den übrigen Bestandteilen des erfindungsgemäßen strahlungsempfindlichen Gemisches gut verträglich ist und insbesondere im Wellenlängenbereich von 190 bis 300 nm eine möglichst geringe Eigenabsorption, d.h. eine hohe Transparenz, aufweist. Bindemittel auf der Basis von Novolak-Kondensationsharzen, die in der Regel in Kombination mit Naphthochinondiaziden als photoaktive Komponenten eingesetzt werden, erfüllen diese Bedingung nicht. Zwar lassen Novolak-Kondensationsharze nach bildmäßiger Belichtung in den nicht belichteten Bereichen eine Erniedrigung der Löslichkeit gegenüber wäßrig-alkalischen Entwicklern erkennen, doch ist ihre Eigenabsorption im Bereich der für die Bestrahlung gewünschten kurzen Wellenlänge unerwünscht hoch.

Novolak-Kondensationsharze können aber in Mischung mit anderen als Bindemittel geeigneten Harzen mit höherer Transparenz eingesetzt werden. Die Mischungsverhältnisse richten sich dabei vorwiegend nach der Art des mit dem Novolakharz zu mischenden Bindemittels. Insbesondere spielen dessen Grad an Eigenabsorption im genannten Wellenlängenbereich, aber auch die Mischbarkeit mit den anderen Bestandteilen des strahlungsempfindlichen Gemisches eine entscheidende Rolle. Im allgemeinen kann aber das Bindemittel des erfindungsgemäßen strahlungsempfindlichen Gemisches bis zu 30 Gew.-%, insbesondere bis zu 20 Gew.-%, eines Novolak-Kondensationsharzes enthalten.

Als Bindemittel geeignet sind Homo- oder Copolymere des 4-Hydroxystyrols sowie seiner Alkylderivate, z.B. des 3-Methyl-4-hydroxystyrols, sowie Homo- oder Copolymere anderer Vinylphenole, z. B. des 3-Hydroxystyrols oder der Ester oder Amide von Acrylsäure mit phenolischen Gruppen aufweisenden Aromaten. Als Comonomere können polymerisierbare Verbindungen wie Styrol, Methyl(meth)acrylat oder ähnliche eingesetzt werden.

Gemische mit erhöhter Plasmabeständigkeit werden erhalten, wenn zur Herstellung der Bindemittel Silicium enthaltende Vinylmonomere, z. B. Vinyltrimethylsilan, mitverwendet werden. Die Transparenz dieser Bindemittel ist im Deep-UV-Bereich im allgemeinen höher, so daß eine verbesserte Strukturierung möglich ist.

Mit gleichem Erfolg lassen sich auch Homo- oder Copolymere des Maleinimids verwenden. Auch diese Bindemittel zeigen hohe Transparenz im Deep-UV-Bereich. Als Comonomere werden auch hier bevorzugt Styrol, substituierte Styrole, Vinylether, Vinylester, Vinylsilylverbindungen oder (Meth)acrylsäureester eingesetzt.

Schließlich sind darüber hinaus auch Copolymere des Styrols mit Comonomeren verwendbar, die in wäßrig alkalischen Lösungen eine Löslichkeitserhöhung bewirken. Hierzu zählen beispielsweise Maleinsäureanhydrid und Maleinsäurehalbester.

Die genannten Bindemittel können auch untereinander gemischt werden, sofern sich dadurch die optische Qualität des strahlungsempfindlichen Gemisches nicht verschlechtert. Bindemittelgemische sind jedoch nicht bevorzugt.

Die Menge des Bindemittels beträgt im allgemeinen 40 bis 95 Gew.-%, insbesondere 50 bis 90 Gew.-%, bezogen auf das Gesamtgewicht der festen Anteile des strahlungsempfindlichen Gemisches.

Die Extinktion des Bindemittels bzw. der Kombination von Bindemitteln für Strahlung der Wellenlänge 248 nm beträgt bevorzugt weniger als 0,35, besonders bevorzugt weniger als 0,25 $\mu m^{-1}$.

Die Glasübergangstemperatur des Bindemittels bzw. der Kombination von Bindemitteln liegt vorteilhaft bei mindestens 120 °C.

Ferner können den erfindungsgemäßen strahlungsempfindlichen Gemischen gegebenenfalls Farbstoffe, Pigmente, Weichmacher, Netzmittel und Verlaufmittel, aber auch Polyglykole, Celluloseether, z. B. Ethylcellulose, zur Erfüllung spezieller Erfordernisse, wie Flexibilität, Haftung und Glanz, zugesetzt werden.

Soll ein Substrat beschichtet werden, so wird das erfindungsgemäße strahlungsempfindliche Gemisch zweckmäßig in einem Lösemittel oder in einer Kombination von Lösemitteln gelöst. Hierfür besonders geeignet sind Ethylenglykol und Propylenglykol sowie die davon abgeleiteten Mono- und Dialkylether, besonders die Mono- und Dimethylether sowie die Mono- und Diethylether, Ester abgeleitet aus aliphatischen $(C_1-C_6)$Carbonsäurenund entweder $(C_1-C_8)$Alkanolen oder $(C_1-C_8)$Alkandiolen oder $(C_1-C_6)$Alkoxy-$(C_1-C_8)$alkanolen, beispielsweise Ethylacetat, Hydroxyethylacetat, Alkoxyethylacetat, n-Butylacetat, Propylenglykolmonoalkyletheracetat, insbesondere Propylenglykolmethyletheracetat und Amylacetat, Ether, wie Tetrahydrofuran und Dioxan, Ketone, wie Methylethylketon, Methylisobutylketon, Cyclopentanon und Cyclohexanon, N,N-Dialkyl-carbonsäureamide, wie N,N-Dimethylformamid und N,N-Dimethylacetamid, aber auch Hexamethylphosphorsäuretriamid, N-Methyl-pyrrolidin2-on und Butyrolacton, sowie beliebige Mischungen davon. Besonders bevorzugt von diesen sind die Glykolether, aliphatischen Ester und Ketone.

Letztendlich hängt die Wahl des Lösemittels bzw. Lösemittelgemisches ab von dem angewandten Beschichtungsverfahren, der gewünschten Schichtstärke und den Trocknungsbedingungen. Ebenso müssen die Lösemittel unter den angewendeten Bedingungen gegenüber den übrigen Schichtbestandteilen chemisch inert sein.

Die mit den genannten Lösemitteln hergestellte Lösung hat in der Regel einen Feststoffgehalt von 5 bis 60 Gew.-%, vorzugsweise bis 50 Gew.-%.

Gegenstand der Erfindung ist schließlich auch ein strahlungsempfindliches Aufzeichnungsmaterial, das im wesentlichen aus einem Substrat und einer darauf befindlichen strahlungsempfindlichen Schicht aus dem erfindungsgemäßen strahlungsempfindlichen Gemisch besteht.

Als Substrate kommen alle Materialien in Frage, aus denen Kondensatoren, Halbleiter, mehrlagige gedruckte Schaltungen oder integrierte Schaltkreise bestehen bzw. hergestellt werden können. Speziell sind Siliciumsubstrate zu nennen, die auch thermisch oxidiert und/oder mit Aluminium beschichtet, aber auch dotiert sein können. Daneben sind alle anderen in der Halbleitertechnologie üblichen Substrate möglich, wie Siliciumnitrid, Galliumarsenid und Indiumphosphid. Weiterhin kommen die aus der Flüssigkristalldisplay-Herstellung bekannten Substrate in Frage, wie z. B. Glas und Indium-Zinnoxid, ferner Metallplatten und -folien - beispielsweise aus Aluminium, Kupfer, Zink-, Bimetall- und Trimetallfolien, aber auch elektrisch nichtleitende Folien, die mit Metallen bedampft sind, und Papier. Diese Substrate können thermisch vorbehandelt, oberflächlich aufgerauht, angeätzt oder, zur Verbesserung erwünschter Eigenschaften, z. B. zur Erhöhung der Hydrophilie, mit Chemikalien vorbehandelt sein.

Um der strahlungsempfindlichen Schicht einen besseren Zusammenhalt und/oder eine bessere Haftung auf der Substratoberfläche zu verleihen, kann in ihr ein Haftvermittler enthalten sein. Bei Silicium- bzw. Siliciumdioxid-Substraten kommen hierfür Haftvermittler vom Aminosilan-Typ, wie z. B. 3-Aminopropyltriethoxysilan oder Hexamethyldisilazan, in Frage.

Geeignete Träger für die Herstellung von photomechanischen Aufzeichnungsschichten, wie Druckformen für den Hochdruck, Flachdruck, Siebdruck und Flexodruck sind besonders Aluminiumplatten, die gegebenenfalls vorher anodisch oxidiert, gekörnt und/oder silikatisiert werden, daneben Zink- und Stahlplatten, die gegebenenfalls verchromt werden, sowie Kunststoffolien und Papier.

Das erfindungsgemäße Aufzeichnungsmaterial wird mit aktinischer Strahlung bildmäßig belichtet. Als Strahlungsquellen eignen sich besonders Metallhalogenidlampen, Kohlebogenlampen, Xenonlampen und Quecksilberdampflampen. Ebenso kann eine Belichtung mit energiereicher Strahlung wie Laser-, Elektronen- oder Röntgenstrahlung erfolgen. Besonders bevorzugt sind jedoch Lampen, die Licht einer Wellenlänge von 190 bis 260 nm ausstrahlen können, d.h. insbesondere Xenon- und Quecksilberdampflampen. Darüber hinaus lassen sich auch Laserlichtquellen verwenden, z. B. Excimerlaser, insbesondere KrF- oder ArF-Laser, die bei 248 bzw. 193 nm emittieren. Die Strahlungsquellen müssen in den genannten Wellenlängenbereichen eine ausreichende Emission aufweisen.

Die Stärke der lichtempfindlichen Schicht hängt vom Verwendungszweck ab. Sie beträgt im allgemeinen zwischen 0,1 und 100 $\mu$m, bevorzugt zwischen 0,5 und 10 $\mu$m, besonders bevorzugt um 1,0 $\mu$m.

Gegenstand der Erfindung ist ferner ein Verfahren zur Herstellung eines strahlungsempfindlichen Aufzeichnungsmaterials. Das Auftragen des strahlungsempfindlichen Gemisches auf das Substrat kann durch Aufsprühen, Fließbeschichten, Walzen, Schleuder- und Tauchbeschichten erfolgen. Danach wird das Lösemittel durch Verdampfen entfernt, so daß auf der Oberfläche des Substrats die strahlungsempfindliche Schicht zurückbleibt. Die Entfernung des Lösemittels kann durch Erhitzen der Schicht auf Temperaturen bis zu 150 °C gefördert werden. Das Gemisch kann aber auch zunächst auf obengenannte Weise auf einen Zwischenträger aufgetragen werden, von dem aus es unter Druck und erhöhter Temperatur auf das endgültige Trägermaterial übertragen wird. Als Zwischenträger können grundsätzlich alle auch als Trägermaterialien geeigneten Materialien Anwendung finden. Anschließend wird die Schicht bildmäßig bestrahlt. Danach behandelt man die Schicht mit einer Entwicklerlösung, die die bestrahlten Bereiche der Schicht löst und entfernt, so daß ein Abbild der bei der bildmäßigen Bestrahlung verwendeten Vorlage auf der Substratoberfläche verbleibt.

Als Entwickler eignen sich besonders wäßrige Lösungen, die Silikate, Metasilikate, Hydroxide, Hydrogen- und und Dihydrogenphosphate, Carbonate oder Hydrogencarbonate von Alkalimetall-, Erdalkalimetall- und/oder Ammoniumionen enthalten, aber auch Ammoniak und dergleichen. Metallionenfreie Entwickler werden in der US-A 4 729 941, der EP-A 0 062 733, der US-A 4 628 023, der US-A 4 141 733,

7

der EP-A 0 097 282 und der EP-A 0 023 758 beschrieben. Der Gehalt dieser Substanzen in der Entwicklerlösung beträgt im allgemeinen 0,1 bis 15 Gew.-%, vorzugweise 0,5 bis 5 Gew.-%, bezogen auf das Gewicht der Entwicklerlösung. Metallionenfreie Entwickler werden bevorzugt verwendet. Den Entwicklern können gegebenenfalls geringe Mengen eines Netzmittels zugesetzt sein, um die Ablösung der löslichen Bereiche der Schicht zu erleichtern.

Die entwickelten Schichtstrukturen können nachgehärtet werden. Dies geschieht im allgemeinen durch Erhitzen auf einer hot-plate bis zu einer Temperatur unterhalb der Fließtemperatur und anschließendes ganzflächiges Belichten mit dem UV-Licht einer Xenon-Quecksilber-Dampflampe (Bereich von 200 bis 250 nm). Durch die Nachhärtung werden die Bildstrukturen vernetzt, so daß sie im allgemeinen eine Fließbeständigkeit bis zu Temperaturen von über 200 °C aufweisen. Die Nachhärtung kann auch ohne Temperaturerhöhung allein durch Bestrahlen mit energiereichem UV-Licht erfolgen.

Verwendung findet das erfindungsgemäße strahlungsempfindliche Gemisch bei der Herstellung von integrierten Schaltungen oder von einzelnen elektrischen Bausteinen mit lithographischen Prozessen, da sie eine hohe Lichtempfindlichkeit aufweisen, besonders bei Bestrahlung mit Licht einer Wellenlänge zwischen 190 bis 300 nm. Da die Gemische bei Belichtung sehr gut ausbleichen, lassen sich feinere Strukturen erzielen als dies mit den bekannten Gemischen möglich ist. Die entwickelte Resistschicht dient dabei als Maske für die folgenden Prozeßschritte. Solche Schritte sind z. B. das Ätzen des Schichtträgers, das Implantieren von Ionen in den Schichtträger oder das Abscheiden von Metallen oder anderen Materialien auf dem Schichtträger.

Die nachstehend beschriebenen Beispiele illustrieren die Erfindung, sollen aber nicht beschränkend wirken.

Synthesebeispiel

1,3,5-Tris-methansulfonyloxy-benzol

Zu einer Lösung von 12,6 g (0,10 mol) Phloroglucin und 101 g (1,0 mol) N-Methylmorpholin in 200 ml trockenem Tetrahydrofuran wurden bei 0 °C 39,8 g (0,33 mol) Methansulfonsäurechlorid innerhalb von 30 min so langsam zugetropft, daß die Temperatur nicht über 10 °C anstieg. Nach dem Zutropfen entfernte man das Eisbad, ließ auf Raumtemperatur erwärmen und rührte 2 h bei dieser Temperatur. Die Mischung wurde nun unter ständigem Rühren in 3 l Eiswasser langsam eingetropft, der entstandene Niederschlag abgesaugt und mit Wasser neutral gewaschen. Nach dem Trocknen wurden 32,9 g (91 %) eines farbloses Pulvers mit Schmelzpunkt 145 bis 149 °C erhalten. Die Umkristallisation aus einem Lösemittelgemisch Isopropanol/Aceton ergab farblose, stark lichtbrechende Plättchen mit einem Schmelzpunkt von 150 °C.

Die Analyse dieser Verbindung ergab folgende Werte:

| ber.: | C 30,00 % | H 3,36 % | S 26,69 % |
| gef.: | C 29,8 % | H 3,2 % | S 26,5 % |

Auf analoge Weise lassen sich auch andere der weiter oben beschriebenen mehrfunktionellen Hydroxyaromaten mit Sulfonsäuren $RSO_3H$ verestern.

Die Charakterisierung der mehrfunktionellen Sulfonsäureester erfolgte durch $^1$H- und $^{13}$C-Hochfeld-Kernresonanzspektren sowie durch Elementaranalysen und ggf. IR-spektroskopisch zum Beweis der Abwesenheit freier Hydroxygruppen im Produkt.

Anwendungsbeispiele 1 bis 4

Die Beispiele 1 bis 4 belegen die Eignung des erfindungsgemäßen Gemisches für Aufzeichnungsmaterialien in der Mikrolithographie unter Verwendung unterschiedlichster Strahlungsquellen. Anhand der Vergleichsbeispiele 5 und 6 wird die Überlegenheit der erfindungsgemäßen Gemische gegenüber dem Stand der Technik gezeigt. Gt steht im Folgenden für Gewichtsteile.

Beispiel 1

Es wurde eine Beschichtungslösung hergestellt aus

| 4,5 Gt | eines Homopolymeren aus 3-Methyl-4-hydroxystyrol mit einem Erweichungsbereich um 155 °C und einem mittleren Molekulargewicht um 25.000 [bestimmt durch Gelpermeationschromatographie (GPC)], |
|---|---|
| 3,0 Gt | eines N,O-Polyacetals, hergestellt aus Benzaldehyd-dimethylacetal und N-Propylcarbamidsäure-(2-hydroxy-ethyl)-ester gemäß Herstellungsbeispiel 1 der gleichzeitig eingereichten Patentanmeldung P 41 12 968.7 und |
| 0,4 Gt | 1,3,5-Tris-methansulfonyloxy-benzol gemäß Synthesebeispiel, in |
| 42 Gt | Propylenglykol-monomethylether-acetat. |

Die Beschichtungslösung wurde durch einen Filter mit einem Porendurchmesser von 0,2 $\mu$m filtriert und auf einen mit einem Haftvermittler (Hexamethyldisilazan) vorbehandelten Wafer aufgeschleudert. Die Schleuderdrehzahl wurden dabei so gewählt, daß man nach der Trocknung bei 130 °C für 1 min auf der hot plate Schichtdicken um 1,07 $\mu$m erhielt.

Das Aufzeichnungsmaterial wurde bildmäßig unter einer Vorlage mit der UV-Strahlung eines KrF-Excimerlasers (248 nm) mit einer Energie von 12,4 mJ/cm$^2$ belichtet und anschließend bei 60 °C für 1 min einem post exposure bake auf einer hot plate unterzogen.

Entwickelt wurde das Aufzeichnungsmaterial mit einer 0,27 n wäßrigen Tetramethylammoniumhydroxid-Lösung. Nach einer Entwicklungsdauer von 30 s erhielt man ein fehlerfreies Abbild der Maske mit steilen Resistflanken, wobei auch Strukturen < 0,4 $\mu$m detailgetreu aufgelöst waren. Eine Untersuchung der Flanken der Resistprofile mittels Rasterelektronenmikroskopie belegte, daß diese praktisch senkrecht zur Substratoberfläche ausgerichtet waren.

Die in den Beispielen 2 bis 4 beschriebenen, strahlungsempfindlichen Aufzeichnungsmaterialien ergaben ebenfalls ein fehlerfreies Abbild der Maske mit steilen Resistflanken, wobei auch Strukturen < 0,40 $\mu$m detailgetreu aufgelöst waren. Die Resistflanken waren in allen Fällen nahezu senkrecht zur Substratoberfläche ausgerichtet.

Beispiel 2:

Es wurde eine Beschichtungslösung hergestellt aus

| 4,5 Gt | eines Copolymeren aus Styrol/p-Hydroxystyrol (80/20) mit einem mittleren Molekulargewicht von 32.000, |
|---|---|
| 3,0 Gt | eines O,O-Polyacetals, hergestellt aus Benzaldehyd-dimethylacetal und Tricyclo[5.2.1.0$^{2,6}$]decandiyl-bis-methanol ("TCD-Alkohol"-Isomerengemisch), hergestellt analog dem Herstellungsbeispiel 1 der DE-A 37 30 787 und |
| 0,5 Gt | 1,3,5-Tris-(4-brom-benzolsulfonyloxy)-benzol, hergestellt analog dem Synthesebeispiel, in |
| 42 Gt | Propylenglykol-monomethylether-acetat. |

Beschichtungs-, Trocknungs- und Entwicklungsbedingungen entsprachen Beispiel 1 (post exposure bake: 90 °C/1 min).

Das Aufzeichnungsmaterial wurde bildmäßig unter einer Vorlage mit der UV-Strahlung einer Xenon-Quecksilberdampflampe bei 260 nm (mit einem Interferenzfilter) mit einer Energie von 17,6 mJ/cm$^2$ belichtet und 45 s entwickelt.

Beispiel 3

Ein entsprechend Beispiel 1 hergestellter Wafer wurde unter einer Vorlage mit UV-Licht einer Xenon-Quecksilberdampflampe mit einer Wellenlänge von 260 nm (mit einer Energie von 13,4 mJ/cm$^2$ bestrahlt. Nach der Entwicklung wie in Beispiel 1 wurde ein originalgetreues Abbild der Vorlage erhalten, in dem auch Strukturen im Sub-Halbmikrometer-Bereich detailgetreu wiedergegeben waren.

Beispiel 4

Es wurde eine Beschichtungslösung hergestellt aus

| | |
|---|---|
| 7,0 Gt | eines Copolymeren aus 3-Methyl-4-hydroxystyrol/4-Hydroxystyrol (Molverhältnis 72:28) mit einem Erweichungsbereich um 160 °C und einem mittleren Molekulargewicht von 28.000 (GPC), |
| 3,0 Gt | eines N,O-Polyacetals, hergestellt aus 3,4-Methylendioxy-benzaldehyd-dimethylacetal und N-Hexyl-carbamidsäure-(2-hydroxyethyl)-ester, gemäß Herstellungsbeispiel 1 der gleichzeitig eingereichten Patentanmeldung P 41 12 968.7 und |
| 1,0 Gt | 1-Octanoyl-2,3,4-tris-(toluol-4-sulfonyloxy)-benzol, hergestellt analog dem Synthesebeispiel, in |
| 42 Gt | Propylenglykol-monomethylether-acetat. |

Die Lösung wurde wie in Beispiel 1 vorbehandelt, auf-geschleudert, getrocknet und das Aufzeichnungsmaterial bildmäßig mit einer Energie von 16,8 mJ/cm$^2$ belichtet (Xenon-Quecksilberdampflampe). Nach dem post exposure bake (80 °C/1 min) wurde wie in Beispiel 1 entwickelt, wobei die belichteten Bereiche innerhalb von 60 s rückstandsfrei abgelöst wurden.

Beispiel 5

Wie in Beispiel 1 beschrieben, wurde ein Wafer hergestellt mit einer Beschichtungslösung, die der in Beispiel 4 genannten gleicht, mit der einzigen Abweichung, daß anstelle des dort eingesetzten 1,0 Gt 1-Octanoyl-2,3,4-tris-(toluol-4-sulfonyloxy)-benzol nunmehr 0,8 Gt 2,3,4-Tris-methansulfonyloxy-benzophenon, hergestellt analog dem Synthesebeispiel, verwendet wurde. Der Wafer wurde dann bildmäßig mit einer Energie von 10,7 mJ/cm$^2$ belichtet (Xenon-Quecksilberdampflampe). Nach einem post exposure bake (80 °C/1 min) wurde wie in Beispiel 1 beschrieben entwickelt, wobei die belichteten Bereiche innerhalb von 60 s rückstandsfrei abgelöst wurden.

Beispiele 6 und 7 (Vergleichsbeispiele)

Die Resistformulierung des Beispiels 1 wurde derart abgeändert, daß die dort verwendete säurebildende Verbindung durch die gleiche Menge an 1,2,3-Tris-methansulfonyloxy-benzol (Beispiel 6) oder 2,1-Diazonaphthochinon-4-sulfonsäureester des 4,4-Bis-(4-hydroxyphenyl)-valeriansäure-(2-ethoxy-ethyl)esters (Beispiel 7) ersetzt wurde.

Um diese Formulierungen mit Strahlung einer Wellenlänge von 260 nm (Xenon-Quecksilberdampflampe) ausreichend zu belichten, war eine Energiedosis von 26 mJ/cm$^2$ (Beispiel 6) bzw. 92 mJ/cm$^2$ (Beispiel 7) erforderlich. Die in den Vergleichsbeispielen verwendeten, literaturbekannten photoaktiven Säurebildner zeigten in den Resistformulierungen eine z. T. deutlich verringerte Empfindlichkeit gegenüber den erfindungsgemäßen Gemischen.

**Patentansprüche**

1. Positiv arbeitendes strahlungsempfindliches Gemisch mit
   a) einer Verbindung, die unter Einwirkung von aktinischer Strahlung eine starke Säure bildet,
   b) einer Verbindung mit mindestens einer durch Säure spaltbaren C-O-C- oder C-O-Si-Bindung und
   c) einem in Wasser unlöslichen, in wäßrigalkalischen Lösungen löslichen oder zumindest quellbaren polymeren Bindemittel,
   dadurch gekennzeichnet, daß die Verbindung (a) ein mit Sulfonsäuren der allgemeinen Formel R-SO$_3$H verestertes 1,3,5- oder 1,2,4-Trihydroxybenzol oder ein am aromatischen Ring mit einem Rest R' substituiertes 1,2,3-, 1,3,5- oder 1,2,4-Trihydroxy-benzol darstellt, wobei R und R' gleiche oder verschiedene Bedeutung haben und R einen ggf. weiter substituierten ($C_1$-$C_{10}$)Alkyl-, ($C_5$-$C_{10}$)Cycloalkyl-, ($C_6$-$C_{10}$)Aryl-, ($C_6$-$C_{10}$)Aryl-($C_1$-$C_{10}$)alkyl- oder ($C_3$-$C_9$)Heteroarylrest und R' einen der für R genannten Reste, einen ($C_1$-$C_{10}$)Alkanoyl-, ($C_1$-$C_{16}$)Alkoxycarbonyl- oder einen ($C_7$-$C_{11}$)Aroylrest bezeichnet.

2. Positiv arbeitendes strahlungsempfindliches Gemisch nach Anspruch 1, dadurch gekennzeichnet, daß die Trihydroxybenzole vollständig mit der Sulfonsäure R-SO$_3$H verestert sind.

3. Positiv arbeitendes strahlungsempfindliches Gemisch gemäß einem der Ansprüche 1 oder 2, dadurch gekennzeichnet, daß der Rest R substituiert ist mit mindestens einem Substituenten ausgewählt aus der Gruppe bestehend aus ($C_1$-$C_8$)Alkyl, ($C_1$-$C_8$)Alkoxy, ($C_1$-$C_8$)Alkanoyl, ($C_1$-$C_8$)Alkanoyloxy, ($C_6$-$C_{10}$)-

Aryl, Cyano oder Halogen.

4.  Positiv arbeitendes strahlungsempfindliches Gemisch gemäß Anspruch 3, dadurch gekennzeichnet, daß die $(C_1\text{-}C_{10})$Alkylreste R vorzugsweise vollständig mit Fluor substituiert sind.

5.  Positiv arbeitendes strahlungsempfindliches Gemisch gemäß Anspruch 4, dadurch gekennzeichnet, daß die aromatischen Reste R' substituiert sind mit mindestens einem Substituenten ausgewählt aus der Gruppe bestehend aus $(C_1\text{-}C_8)$Alkyl, $(C_1\text{-}C_8)$Alkoxy, $(C_1\text{-}C_8)$Alkanoyl, $(C_1\text{-}C_8)$Alkanoyloxy, Halogen und Sulfonyloxy der allgemeinen Formel $-O\text{-}SO_2\text{-}R$, in der R die im Anspruch 1 angegebene Bedeutung hat.

6.  Positiv arbeitendes strahlungsempfindliches Gemisch gemäß einem oder mehreren der Ansprüchen 1 bis 5, dadurch gekennzeichnet, daß die Verbindung a) einen Anteil von 0,5 bis 25 Gew.-%, bevorzugt 2 bis 15 Gew.-%, am Gesamtgewicht der Feststoffe des Gemisches hat.

7.  Positiv arbeitendes strahlungsempfindliches Aufzeichnungsmaterial gemäß einem oder mehreren der Ansprüche 1 bis 6, dadurch gekennzeichnet, daß die Verbindung (b) mit mindestens einer durch Säure spaltbaren C-O-C- oder C-O-Si-Bindung einen Anteil von 1 bis 50 Gew.-%, bevorzugt 10 bis 40 Gew.-%, am Gesamtgewicht der Feststoffe der strahlungsempfindlichen Schicht hat.

8.  Positiv arbeitendes strahlungsempfindliches Gemisch gemäß einem oder mehreren der Ansprüche 1 bis 7, dadurch gekennzeichnet, daß das Bindemittel c) bis zu 30 Gew.-%, insbesondere bis zu 20 Gew.-%, eines Novolak-Kondensationsharzes enthält.

9.  Positiv arbeitendes strahlungsempfindliches Gemisch gemäß einem oder mehreren der Ansprüche 1 bis 8, dadurch gekennzeichnet, daß das Bindemittel c) für Strahlung der Wellenlänge 248 nm eine Extinktion von $< 0,35\ \mu m^{-1}$, bevorzugt $< 0,25\ \mu m^{-1}$, aufweist.

10. Positiv arbeitendes strahlungsempfindliches Gemisch gemäß einem oder mehreren der Ansprüche 1 bis 9, dadurch gekennzeichnet, daß das Bindemittel c) in einem Anteil von 40 bis 95 Gew.-%, bevorzugt 50 bis 90 Gew.-%, am Gesamtgewicht der Feststoffe des Gemisches hat.

11. Positiv arbeitendes strahlungsempfindliches Aufzeichungsmaterial, bestehend aus einem Träger mit einer strahlungsempfindlichen Schicht, dadurch gekennzeichnet, daß die Schicht aus einem strahlungshärtbaren Gemisch gemäß einem oder mehreren der Ansprüche 1 bis 10 besteht.

Europäisches
Patentamt

**EUROPÄISCHER RECHERCHENBERICHT**

Nummer der Anmeldung

EP    92 10 6137

## EINSCHLÄGIGE DOKUMENTE

| Kategorie | Kennzeichnung des Dokuments mit Angabe, soweit erforderlich, der maßgeblichen Teile | Betrifft Anspruch | KLASSIFIKATION DER ANMELDUNG (Int. Cl.5) |
|---|---|---|---|
| X | EP-A-0 388 813 (HITACHI LTD.) <br> * Spalte 4, Zeile 25 - Zeile 35; Ansprüche; Beispiel 7 * | 1-3 | G03F7/004 |
| Y | * das ganze Dokument * | 1-10 | |
| | --- | | |
| Y | EP-A-0 315 748 (HOECHST AKTIENGESELLSCHAFT) <br> * Beispiel 1 * | 1-10 | |
| D | & DE-A-3 730 787 | | |
| | --- | | |
| A | MICROELECTRONIC ENGINEERING <br> Bd. 13, Nr. 1/4, März 1991, AMSTERDAM, NL <br> Seiten 33 - 36; <br> L. SCHLEGEL ET AL.: 'Highly Sensitive Positive Deep UV Resist Utilizing a Sulfonate Acid Generator and a Tetrahydropyranyl Inhibitor' <br> * das ganze Dokument * | 1-10 | |
| | --- | | |
| A | EP-A-0 330 386 (AMERICAN TELEPHONE AND TELEGRAPH COMPANY) <br> * Beispiele 2,3 * | 1-10 | |
| | --- | | **RECHERCHIERTE SACHGEBIETE (Int. Cl.5)** |
| P,A | CHEMICAL ABSTRACTS, vol. 115, no. 3, <br> 22. Juli 1991, Columbus, Ohio, US; <br> abstract no. 28886K, <br> Seite 729 ; | 1-3 | G03F |
| A | & DD-A-286 351 (HUMBOLDT UNIVERSITÄT ZU BERLIN) <br> 24. Januar 1991 <br> * Zusammenfassung * | | |
| | --- | | |
| A | DE-A-1 902 583 (HOFFMANN-LA ROCHE) <br> * Ansprüche 10,11 * | 1,2 | |
| | ----- | | |

Der vorliegende Recherchenbericht wurde für alle Patentansprüche erstellt

| Recherchenort | Abschlußdatum der Recherche | Prüfer |
|---|---|---|
| BERLIN | 10 AUGUST 1992 | STOCK H. |

EPO FORM 1503 03.82 (P0403)